Europäisches Patentamt

European Patent Office

Office européen des brevets

(19)

(11) Veröffentlichungsnummer: **0 061 528**
**B1**

(12) **EUROPÄISCHE PATENTSCHRIFT**

(45) Veröffentlichungstag der Patentschrift:
02.05.85

(51) Int. Cl.⁴: **H 05 K 7/14**

(21) Anmeldenummer: **81109429.1**

(22) Anmeldetag: **30.10.81**

(54) **Magazin für einschiebbare elektrische Baugruppen.**

(30) Priorität: **30.03.81 DE 3112644**

(43) Veröffentlichungstag der Anmeldung:
**06.10.82 Patentblatt 82/40**

(45) Bekanntmachung des Hinweises auf die Patenterteilung:
**02.05.85 Patentblatt 85/18**

(84) Benannte Vertragsstaaten:
**AT BE CH FR GB IT LI NL**

(56) Entgegenhaltungen:
**DE - A - 2 743 428**

(73) Patentinhaber: **Siemens Aktiengesellschaft, Berlin und München Wittelsbacherplatz 2, D-8000 München 2 (DE)**

(72) Erfinder: **Niggl, Heinz, Lindenberg 149, D-8134 Pöcking (DE)**
Erfinder: **Zell, Karl, Moritz-von-Schwind-Weg 80, D-8130 Niederpöcking (DE)**
Erfinder: **Jellen, Franz, Neuherbergstrasse 44, D-8000 München 45 (DE)**

ACTORUM AG

**Beschreibung**

Die Erfindung bezieht sich auf ein Magazin für einschiebbare elektrische Baugruppen, die untereinander durch eine Rückwandverdrahtung verbunden sind, welche eine gedruckte Leiterplatte und durch Schaltdrähte verbundene Kontaktstifte aufweist.

Durch die deutsche Offenlegungsschrift 2743428 ist es bekannt, auf die frei bleibenden Enden der Kontaktstifte einen Kabelstecker zur externen Verbindung des Magazins aufzustecken. Zwischen den frei bleibenden Enden der Kontaktstifte und dem Verdrahtungsraum der Schaltdrähte ist ein dem jeweiligen Stecker zugeordneter Zentrierkörper angeordnet. Dieser ist über die Kontaktstifte geschoben und fixiert deren freie Enden lagerichtig. Er ist mittels Distanzstücken mit Abstand zur Steckerleiste gehalten. Die Befestigung des Zentrierkörpers erfolgt dabei mit Hilfe der Abstandsstücke an Rahmenteilen des Magazins, die auch die Rückwandsteckerleisten für die einschiebbaren Baugruppen tragen. Das bedeutet, dass der Zentrierkörper jeweils einem Rückwandstecker zugeordnet ist.

Ein Baugruppenmagazin weist in der Regel zumindest eine gedruckte Leiterplatte auf, die der Potentialzuführung dient. Diese Leiterplatte erstreckt sich über die gesamte Rückwand. Um an jeder beliebigen Stelle einen Zentrierkörper anordnen zu können, muss die Leiterplatte entsprechend viele Löcher aufweisen, um die Zentrierkörper am Magazinrahmen anschrauben zu können. Da in einem Magazin mehrere Steckerreihen übereinander angeordnet sein können, so befinden sich diese Löcher zum Durchtritt der Befestigungsschrauben nicht nur in den Randzonen, sondern auch in der Mitte der Leiterplatte. Die Vielzahl der Löcher behindert die freie Gestaltung der Leiterplatten in bezug auf die Anordnung der Leiterbahnen.

Der Erfindung liegt die Aufgabe zugrunde, die Befestigung der Zentrierkörper zu erleichtern und die Anzahl der Durchgangslöcher in der Rückwandplatte für den Durchtritt der Befestigungsschrauben zu verringern.

Diese Aufgabe wird durch die Erfindung gemäss Anspruch 1 gelöst. Halteschienen mit Löcherreihen benötigen weitaus weniger Stützpunkte an der Rückwand als es für die direkte Befestigung der Zentrierkörper erforderlich wäre. Die Halteschienen sind mit eng aneinandergereihten Haltelöchern versehen, deren Anzahl die der Stützpunkte bei weitem übertrifft. Das bedeutet, dass die Rückwandleiterplatte eine erheblich geringere Anzahl von Durchbrüchen zur Befestigung der Halteschiene benötigt. Die mit Abstand zur Leiterplatte befestigten Halteschienen weisen eng benachbarte Löcher auf, deren Abstand z. B. einer Rasterteilung der Rückwandkontaktstifte entspricht. Dadurch ist es möglich, den Zentrierkörper auch seitlich versetzt zu den Rückwandsteckern für die Baugruppen anzuordnen. Ausserdem erleichtert sich die Montage der Zentrierkörper, da weniger Distanzhülsen benötigt werden, und da die Zentrierkörper unmittelbar mit den Halteschienen verschraubt werden können.

Durch eine Weiterbildung der Erfindung nach Anspruch 2 ist es möglich, dieselben Schrauben zur gleichzeitigen Befestigung der Halteschiene und der Leiterplatte zu verwenden. Dadurch werden keine zusätzlichen Bohrungen in der Leiterplatte zur Befestigung der Halteschienen benötigt.

Durch die Weiterbildung nach Anspruch 3 ist es möglich, an einer Halteschiene übereinander angeordnete Zentrierkörper mit ihren einander zugewandten Enden zu befestigen. Dies verringert die erforderliche Anzahl der Halteschienen sowie die entsprechende Anzahl von Bohrungen in der Leiterplatte.

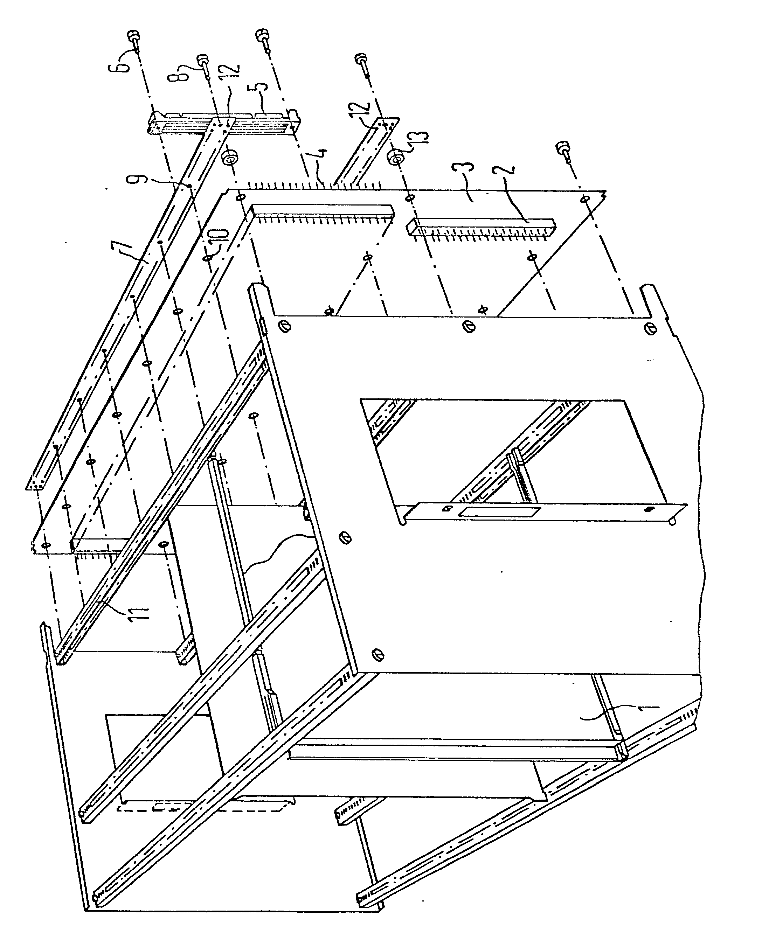

Im folgenden wird die Erfindung anhand eines in der Zeichnung dargestellten Ausführungsbeispieles näher erläutert.

Die dargestellte Figur zeigt ein Magazin für einschiebbare elektrische Baugruppen 1 unmittelbar vor dem Zusammenbau. Die Baugruppen 1 sind über Rückwandstecker 2 durch eine Rückwandverdrahtung verbindbar. Diese Rückwandverdrahtung weist eine gedruckte Leiterplatte 3 auf, die sich über die gesamte Magazinrückwand erstreckt. Auf der Rückseite der gedruckten Leiterplatte 3 ragen aus dieser Kontaktstifte 4 der Rückwandstecker 2 heraus. Diese Kontaktstifte können mittels Schaltdrähten ebenfalls untereinander verbunden werden. Sie sind jedoch so lang, dass auf ihren freibleibenden Enden nicht dargestellte Kabelstecker zur externen Verbindung der Baugruppen aufgesteckt werden können. Über die freibleibenden Enden der Kontaktstifte 4 ist ein Zentrierkörper 5 aufschiebbar, der der genauen Fixierung der Kontaktstiftenden sowie der mechanischen Befestigung des aufzusteckenden Kabelsteckers dient. Dieser Zentrierkörper 5 ist mittels Schrauben 6 an Halteschienen 7 befestigbar. Diese Halteschienen 7 erstrecken sich über die gesamte Länge der Magazinrückwand und sind an dieser mit Abstand zur Leiterplatte 3 mittels weiterer Schrauben 8 befestigbar, die durch entsprechende Befestigungslöcher 9 in den Halteschienen 7 sowie entsprechende Freibohrungen 10 in der Leiterplatte 3 hindurchgeführt und mit waagrechten Trägern 11 des Magazins verschraubt werden können. Zwischen der Leiterplatte 3 und den Halteschienen 7 sind Distanzbuchsen angeordnet, die den für die Verdrahtung der Rückwand erforderlichen Verdrahtungsabstand sichern. Die Befestigungsschrauben 8 dienen somit zugleich der Befestigung der Leiterplatte 3 und der Halteschiene 7.

Die Halteschienen 7 sind mit je einer Doppelreihe eng benachbarter Haltelöcher 12 versehen. Dadurch ist es möglich, die Zentrierkörper 5 variabel und/oder eng benachbart an den Halteschienen 7 zu befestigen. Die Befestigungsschrauben 6 sind vorzugsweise mit selbstschneidendem Gewinde versehen, so dass insbesondere bei einer geringen Anzahl von Zentrierkörpern verhältnismässig wenige Haltelöcher 12 mit Gewinde versehen werden.

## Patentansprüche

1. Magazin für einschiebbare elektrische Baugruppen, die untereinander durch eine Rückwandverdrahtung verbunden sind, welche eine gedruckte Leiterplatte und durch Schaltdrähte verbundene Kontaktstifte aufweist, auf deren freibleibenden Enden Kabelstecker zur externen Verbindung aufsteckbar sind, wobei zwischen den freibleibenden Enden der Kontaktstifte und dem Verdrahtungsraum der Schaltdrähte ein dem jeweiligen Stecker zugeordneter Zentrierkörper angeordnet ist, der über die Kontaktstiftenden geschoben ist und diese lagerichtig fixiert und der mit Abstand zur Leiterplatte am Magazin befestigt ist, dadurch gekennzeichnet, dass auf der den Baugruppen (1) abgewandten Seite der Leiterplatte (3) Halteschienen (7) am Magazin befestigt sind, die mit Lochreihen (12) zum Anschrauben der Zentrierkörper (5) versehen sind.

2. Magazin nach Anspruch 1, dadurch gekennzeichnet, dass die Halteschienen (7) an einem Rahmen des Magazins mittels Schrauben (8) befestigt sind, die durch Bohrungen (10) der Leiterplatte hindurchgeführt sind, dass zwischen der Leiterplatte (3) und den Halteschienen (7) die Schrauben (8) umgreifende Distanzhülsen (13) angeordnet sind und dass die Schrauben (8) zugleich der Befestigung der Leiterplatte (3) an dem Rahmen dienen.

3. Magazin nach Anspruch 1 oder 2, dadurch gekennzeichnet, dass die Halteschienen je zwei Lochreihen (12) zur Befestigung der Zentrierkörper (5) aufweisen.

## Claims

1. A cabinet for insertable electric assemblies which are connected to one another by a rear wall wiring which has a printed circuit board and contact pins, connected by jumper wires, and to the free ends of which are attached cable plugs for external connection, there being arranged between the free ends of the contact pins and the wiring chamber of the jumper wires a centering body assigned to the plug in question and placed over the ends of the contact pins to fix these in the correct position, which body is attached to the cabinet at a distance from the circuit board, characterised in that support bars (7) are attached to the cabinet on that side of the circuit board (3) which faces away from the assemblies (1) and are provided with rows of holes for screw attachment of the centring bodies (5).

2. A cabinet as claimed in claim 1, characterised in that the support bars (7) are attached to a frame of the cabinet by means of screws (8) which are passed through bores (10) in the circuit board, that between the circuit board (3) and the support bars (7) are arranged spacer sleeves (13) which encompass the screws (8), and that the screws (8) serve simultaneously to attach the circuit board (3) to the frame.

3. A cabinet as claimed in claim 1 or 2, characterised in that the support bars each possess two rows of holes (12) for the attachment of the centering bodies (5).

## Revendications

1. Magasin pour modules électriques enfichables, qui sont reliés les uns aux autres par un câblage, disposé sur la paroi arrière et qui comporte une plaquette à circuits imprimés et des broches de contact reliées par des fils de connexion et sur les extrémités libres desquelles des connecteurs à câble peuvent être enfichés pour établir une liaison extérieure, et dans lequel entre les extrémités libres des broches de contact et l'espace de câblage des fils de connexion se trouve disposé un corps de centrage associé au connecteur respectif et qui est repoussé par-dessus les extrémités des broches de contact et bloque des dernières en position correcte et est fixé à distance de la plaquette à circuits imprimés dans le magasin, caractérisé par le fait que sur la face de la plaquette à circuits imprimés (3), située à l'opposé des modules (3) se trouvent fixés dans le magasin, des rails de maintien (7) qui sont équipés de séries de trous (12) permettant le vissage des corps de centrage (5).

2. Magasin suivant la revendication 1, caractérisé par le fait que les rails de guidage (7) sont fixés sur un cadre du magasin au moyen de vis (8) qui traversent des perçages (10) de la plaquette à circuits imprimés, que des bagues entretoises (13) entourant les vis (8) sont disposées entre la plaquette à circuits imprimés (3) et les rails de maintien (7), et que les vis (8) servent simultanément à assurer la fixation de la plaquette à circuits imprimés (3) sur le cadre.

3. Magasin suivant la revendication 1 ou 2, caractérisé par le fait que les rails de maintien comportent respectivement deux rangées de trous (12) servant à fixer les corps de centrage (5).